# EUROPÄISCHE PATENTANMELDUNG

(11) **EP 4 351 004 A1**
(43) Veröffentlichungstag der Anmeldung: **10.04.2024**
(21) Anmeldenummer: 23193434.0
(22) Anmeldetag: 25.08.2023
(51) Int. Cl.: H03M 9/00, G06F 13/42, H04N 21/00

(54) **SELBSTKONFIGURIERENDE AUFZEICHNUNGSVORRICHTUNG FÜR BILDDATEN VON EINER BILDGEBENDEN SENSORVORRICHTUNG**

(30) Priorität: 07.10.2022 DE 102022125946
(71) Anmelder: dSPACE GmbH, 33102 Paderborn (DE)
(72) Erfinder: Spilker, Marco, 33102 Paderborn (DE); Sievers, Gregor, 33102 Paderborn (DE); Lindemann, Christian, 33102 Paderborn (DE)

(57) **Zusammenfassung**

Aufzeichnungsvorrichtung für einen Mitschnitt eines serialisierten Bilddatenstroms von einer Sensorvorrichtung. Die Aufzeichnungsvorrichtung umfasst einen Deserialisierer zur Deserialisierung des Bilddatenstroms. Zur Konfiguration des ersten Deserialisierers umfasst die Aufzeichnungsvorrichtung eine Konfigurationsvorrichtung, die einen von einer Empfangsvorrichtung übermittelten Konfigurationsdatenstrom zur Konfiguration eines in der Sensorvorrichtung angeordneten Serialisierers mitschneidet und durch eine Analyse des Mitschnitts der Konfigurationsdaten eine Konfiguration des Deserialisierers der Aufzeichnungsvorrichtung herleitet. In einer bevorzugten Ausgestaltung geschieht die Herleitung durch eine Abstrahierung der Konfiguration Serialisierers in eine Funktionalität des Serialisierers, eine Herleitung einer Funktionalität des ersten Deserialisierers aus der Funktionalität des ersten Serialisierers, und eine Konkretisierung der Funktionalität des ersten Deserialisierers in eine Konfiguration des ersten Deserialisierers.

## Beschreibung

Die Erfindung betrifft Datenlogger zum Mitschneiden von Bilddaten bildgebender Sensoren. Derartige Datenlogger haben in jüngerer Zeit in der Automobilindustrie an Bedeutung gewonnen. Im Zuge der fortschreitenden Automatisierung werden Fahrzeuge mit bildgebenden Sensorvorrichtungen ausgestattet, beispielsweise Kamera-, RADAR-, LIDAR- oder Ultraschallsensoren, sowie mit Steuergeräten zur Auswertung der von besagten Sensoren erzeugten Bilddaten. Diese Steuergeräte erfüllen im Regelfall sicherheitskritische Aufgaben und können im Bedarfsfall eigenständig in die Steuerung des Fahrzeugs eingreifen (Automatisierungsstufe 2) oder sogar die Steuerung zumindest vorübergehend vollständig übernehmen (Automatisierungsstufe 3, 4 oder 5). Sie benötigen deshalb vor ihrem Feldeinsatz eine aufwendige Evaluierung.

Dafür ist es im Stand der Technik bekannt, während einer Testfahrt eines mit einer bildgebenden Sensorvorrichtung ausgestatteten Testfahrzeugs die von der Sensorvorrichtung erzeugten Bilddaten auf einer Aufzeichnungsvorrichtung, d.h. einem Datenlogger, aufzuzeichnen, um die aufgezeichneten Bilddaten später zur Entwicklung eines Computeralgorithmus einzusetzen, der, eingerichtet auf einem Steuergerät, die Bilddaten einlesen, verwerten und auf Basis der Bilddaten ein automatisiertes Fahrzeug ansteuern kann. Beispielsweise können die aufgezeichneten Bilder zur testweisen Stimulation des Algorithmus verwendet werden, um zu prüfen, ob der Algorithmus die in den Bilddaten aufgezeichneten Verkehrssituationen korrekt einschätzt und den Verkehrssituationen angemessene Steuerbefehle generiert. Die Bilddaten können auch zum Training oder zum Test eines neuronalen Netzes verwendet werden, das vorgesehen ist, für den Algorithmus eine Objektliste von in den Bilddaten erkennbaren Objekten zu erstellen. Die Bilddaten können auch in ein synthetisches Szenario übersetzt werden, das eine in den Bilddaten dargestellte Verkehrssituation als Computersimulation nachstellt, um den Algorithmus bzw. das Steuergerät gefahrlos in einer virtuellen Umwelt zu testen (*Software in the Loop* bzw. *Hardware in the Loop*)*.*

Die Übertragung von Bilddaten von einer Sensorvorrichtung zu einer zur Verarbeitung der Sensordaten eingerichteten Empfangsvorrichtung, z.B. einem Steuergerät, geschieht üblicherweise in serialisierter Form. Dazu umfasst die Sensorvorrichtung einen Serialisierer, der die von der Sensorvorrichtung erzeugten, kontinuierlich eintreffenden Rohbilddaten in einen seriellen Datenstrom umwandelt und diesen über eine Datenverbindung an die Empfangsvorrichtung weiterleitet. Die Empfangsvorrichtung umfasst einen Deserialisierer, der den Bilddatenstrom von der Datenverbindung entgegennimmt, dessen Serialisierung rückgängig macht und den deserialisierten Bilddatenstrom an nachgelagerte Komponenten der Empfangsvorrichtung weiterleitet, z.B. an eine Prozessoreinheit zur Verarbeitung der Bilddaten. Bedeutende Zulieferer dafür geeigneter Serialisierer und Deserialisierer sind Texas Instruments Inc. mit der Produktreihe "FPD-Link" und Maxim Integrated mit der Produktreihe "Gigabit Multimedia Serial Link" (GMSL).

Eine für einen Mitschnitt des Bilddatendatenstroms eingerichtete Aufzeichnungsvorrichtung, z.B. der vorhergehend beschriebene Datenlogger, kann als "Man in the middle" ausgestaltet sein. Eine solche Aufzeichnungsvorrichtung wird derart zwischen der Sensorvorrichtung und der Empfangsvorrichtung angeordnet, dass sie zunächst, anstelle der Empfangsvorrichtung, den Bilddatenstrom aufnimmt, einen Mitschnitt des Bilddatenstroms in einer Speichervorrichtung hinterlegt und den Bilddatenstrom schließlich an die Empfangsvorrichtung weiterleitet. Dabei gibt die Aufzeichnungsvorrichtung sich gegenüber ihren beiden Kommunikationspartnern nicht zu erkennen, sondern täuscht beiden eine unmittelbare Kommunikation mit dem jeweils vorgesehenen Kommunikationspartner, der Sensorvorrichtung bzw. der Empfangsvorrichtung, vor. Alternativ kann die Aufzeichnungsvorrichtung auch ausgestaltet sein, eine Kopie des Bilddatenstroms von einem Signalsplitter aufzunehmen.

In beiden Fällen benötigt die Aufzeichnungsvorrichtung einen eigenen Deserialisierer, um den abgefangenen Bilddatenstrom vor dessen Mitschnitt zu deserialisieren, und in der Ausgestaltung als Man in the middle außerdem einen eigenen Serialisierer, um den Bilddatenstrom vor dessen Weiterleitung an die Empfangsvorrichtung wieder zu serialisieren. Nach Inbetriebnahme übermittelt die Empfangsvorrichtung einen Konfigurationsdatenstrom zur Einrichtung des Serialisierers in der Sensorvorrichtung. Diesen Konfigurationsdatenstrom kann die Aufzeichnungsvorrichtung abfangen oder abhören und unmittelbar zur Einrichtung des eigenen Serialisierers nutzen. Die Einrichtung des in der Aufzeichnungsvorrichtung verbauten Deserialisierers ist aber komplizierter. Dieser muss durch seine Konfiguration den von der Sensorvorrichtung serialisierten Bilddatenstrom rekonstruieren, also die von der Sensorvorrichtung vorgenommene Serialisierung rückgängig machen, um die mit dem Bilddatenstrom übertragenen Bilddaten in eine auslesbare und interpretierbare Form zu bringen. Bei Vorhandensein eines eigenen Serialisierers in der Aufzeichnungsvorrichtung muss außerdem der Bilddatenstrom nach Passage des Serialisierers wieder identisch zu dem von der Sensorvorrichtung ausgegebenen Bilddatenstrom sein. Die korrekte Konfiguration des Deserialisierers, die das bewirkt, ist zwar aus dem Konfigurationsdatenstrom herleitbar, aber diese Herleitung ist nach Stand der Technik eine aufwendige menschliche Serviceleistung, die ein hohes Maß an Spezialwissen voraussetzt und viel Zeit kostet.

Es ist die Aufgabe der Erfindung, die Konfiguration eines Aufzeichnungsgeräts für serialisierte Bilddatenströme, insbesondere eines in dem Aufzeichnungsgeräts verbauten Deserialisierers, zu vereinfachen.

Dazu wird erfindungsgemäß eine Aufzeichnungsvorrichtung für einen Mitschnitt eines serialisierten, von einer Sensorvorrichtung zu einer Empfangsvorrichtung fließenden Bilddatenstroms vorgeschlagen. Unter einer Sensorvorrichtung ist ein beliebiges Sensorsystem zu verstehen, das zur Erzeugung von Bilddaten ausgestaltet ist, aus denen Informationen über eine räumliche Anordnung von Objekten in der Umgebung des Sensorsystems rekonstruierbar ist. Eine Sensorvorrichtung kann beispielsweise ein Radarsystem, ein Lidarsystem, eine Kamera, eine Wärmebildkamera oder ein Sonarsystem sein. Unter einer Empfangsvorrichtung ist eine beliebige technische Vorrichtung zur Aufnahme der von dem Sensorsystem ausgegebenen Bilddaten zu verstehen, beispielsweise ein Steuergerät, das zur Erzeugung von Steuerbefehlen auf Basis der Bilddaten ausgestaltet ist.

Die Aufzeichnungsvorrichtung umfasst eine erste Datenschnittstelle. Die erste Datenschnittstelle ist für eine Einrichtung einer ersten Datenverbindung zwischen der ersten Datenschnittstelle und der Sensorvorrichtung zur Übertragung des Bilddatenstroms an die erste Datenschnittstelle ausgestaltet. Das Aufzeichnungsgerät umfasst weiterhin einen ersten Deserialisierer, der zur Deserialisierung des an der ersten Datenschnittstelle aufgenommenen Bilddatenstroms eingerichtet ist, und eine Speichervorrichtung, die eingerichtet ist, den vom ersten Deserialisierer deserialisierten Bilddatenstrom mitzuschneiden und Bilddaten aus dem Bilddatenstrom auf einem Speichermedium zu speichern. In einer bevorzugten Ausgestaltung umfasst die Aufzeichnungsvorrichtung eine zweite Datenschnittstelle, ausgestaltet zur Einrichtung einer zweiten Datenverbindung zwischen der zweiten Datenschnittstelle und der Empfangsvorrichtung zur Übertragung des Bilddatenstroms an die Empfangsvorrichtung, und einen ersten Serialisierer, der eingerichtet ist, den Bilddatenstrom nach dessen Mitschnitt durch die Speichervorrichtung wieder zu serialisieren und den serialisierten Bilddatenstrom durch die zweite Datenschnittstelle auszugeben. Der erste Serialisierer umfasst eine Vielzahl von Eingangspins zur Aufnahme von Bilddaten.

Die Aufzeichnungsvorrichtung umfasst weiterhin eine Konfigurationsvorrichtung, die eingerichtet ist, einen von der Empfangsvorrichtung über die zweite Datenverbindung an die zweite Datenschnittstelle übertragenen Konfigurationsdatenstrom, der eigentlich zur Einrichtung eines in der Sensorvorrichtung angeordneten zweiten Serialisierers vorgesehen ist, mitzuschneiden. Der zweite Serialisierer ist in der Sensorvorrichtung angeordnet, um einen von einem Sensor ausgegebenen Bilddatenstrom zu serialisieren und den serialisierten Bilddatenstrom auf die erste Datenverbindung einzuspeisen. Die Konfigurationsvorrichtung analysiert die mit dem Konfigurationsdatenstrom übertragenen Konfigurationsdaten und ermittelt anhand der Analyse eine Aufbereitung des serialisierten Bilddatenstroms durch den zweiten Serialisierer. Anhand der durch die Analyse gewonnenen Informationen bezüglich der der Aufbereitung des Bilddatenstroms ermittelt die Aufzeichnungsvorrichtung schließlich eine Konfiguration des ersten Deserialisierers. Diese Konfiguration des ersten Deserialisierers ist derart, dass der gemäß der besagten Konfiguration eingerichtete Deserialisierer den von dem Sensor ausgegebenen Bilddatenstrom rekonstruiert, mit anderen Worten die durch den zweiten Serialisierer durchgeführte Serialisierung des Bilddatenstroms rückgängig macht. Die Konfigurationsvorrichtung ist weiterhin eingerichtet, nach der Ermittlung der Konfiguration des ersten Deserialisierers den ersten Deserialisierer gemäß ebendieser Konfiguration einzurichten.

Sofern die Aufzeichnungsvorrichtung einen zweiten Serialisierer umfasst, um den Bilddatenstrom nach dessen Mitschnitt durch die Speichervorrichtung wieder zu serialisieren und durch die zweite Datenschnittstelle auszugeben, kann die Konfigurationsvorrichtung anhand der Analyse ermitteln, wie der Bilddatenstrom für den ersten Serialisierer aufzubereiten und auf die Eingangspins des ersten Serialisierers zu verteilen ist. In diesem Fall gestaltet die Konfigurationsvorrichtung die Konfiguration des ersten Deserialisierers derart aus, dass der erste Deserialisierer durch seine Konfiguration eingerichtet wird, den Bilddatenstrom wie in der Analyse ermittelt aufzubereiten und auf die Eingangspins des ersten Serialisierers zu verteilen.

Die Konfiguration von Serialisierern und Deserialisierern, insbesondere auch des ersten Serialisierers und des ersten Deserialisierers, geschieht im Normalfall mittels beschreibbarer Register des Serialisierers bzw. Deserialisierers, wobei festgelegte Registerkonfigurationen bestimmte technische Funktionalitäten und Verhaltensweisen des Serialisierers bzw. Deserialisierers bewirken.

Aus der Patentveröffentlichung DE 10 2019 132 476 A1 ist bereits bekannt, die Konfiguration eines Serialisierers zu automatisieren, indem Konfigurationsdaten aus einem Konfigurationsdatenstrom, der eigentlich zur Einrichtung eines Serialisierers einer bestimmten Baureihe vorgesehen ist, ausgelesen und in eine technisch gleichwirkende Konfiguration eines anderen Serialisierers aus einer anderen Baureihe übersetzt werden. Ein wesentlicher Unterschied der vorliegenden Erfindung zu diesem Stand der Technik besteht darin, dass aus dem Konfigurationsdatenstrom zur Einrichtung eines Serialisierers eine Konfiguration eines De-Serialisierers, der dem neu konfigurierten Serialisierer nachgelagert ist und diesen mit einem korrekt deserialisierten Bilddatenstrom versorgen muss, hergeleitet wird.

Bevorzugt gehören der erste Serialisierer in der Aufzeichnungsvorrichtung und der zweite Serialisierer in der Sensorvorrichtung derselben Baureihe an, sind also hinsichtlich ihrer technischen Ausstattung und Einrichtung identisch. Darunter ist insbesondere zu verstehen, dass jede mögliche Konfiguration des zweiten Serialisierers identisch auf den ersten Serialisierer übertragbar ist und dass der erste Serialisierer und der zweite Serialisierer, wenn beide identisch konfiguriert sind, sich in technischer Hinsicht identisch verhalten. Dazu kann der erste Serialisierer auf einer austauschbaren Platine angeordnet sein, sodass für jede Sensorvorrichtung eine individuelle Platine in der Aufzeichnungsvorrichtung verbaut werden kann, auf der ein für die jeweilige Sensorvorrichtung individuell ausgewählter erster Serialisierer angeordnet ist, der derselben Baureihe angehört wie der in der jeweiligen Sensorvorrichtung verbaute zweite Serialisierer. Diese Ausführungsform ist insofern vorteilig, dass der mitgeschnittene Konfigurationsdatenstrom, der ja eigentlich für die Konfiguration des zweiten Serialisierers der Sensorvorrichtung vorgesehen ist, unmittelbar zur Konfiguration des ersten Serialisierers nutzbar ist. Ein Nachteil ist aber der erhöhte Fertigungsaufwand, den der Verbau eines individuellen ersten Serialisierers für jede Sensorvorrichtung bewirkt.

Alternativ können der erste Serialisierer und der zweite Serialisierer auch unterschiedlichen Baureihen angehören. In dieser Ausgestaltung kann das in der schon vorhergehend zitierten DE 10 2019 132 476 A1 beschriebene Verfahren angewandt werden, um die durch die Konfigurationsdaten vorgegebene Konfiguration des zweiten Serialisierers in eine technisch gleichwirkende Konfiguration des ersten Serialisierers zu überführen und den zweiten Serialisierer gemäß der technisch gleichwirkenden Konfiguration zu konfigurieren. Diese Ausgestaltung ist anwendbar, sofern der zur Übertragung der Nutzdaten, d.h. insbesondere der Bilddaten, an die Empfangsvorrichtung vorgesehene Hauptdatenkanal des ersten Serialisierers mit der Empfangsvorrichtung kompatibel ist. Sofern das der Fall ist, entfällt in dieser Ausgestaltung der Verbau eines individuell ausgewählten Serialisierers, was den Fertigungsaufwand der Aufzeichnungsvorrichtung weiter reduziert.

Bevorzugt ist die Aufzeichnungsvorrichtung eingerichtet, den Konfigurationsdatenstrom abzufangen, sodass der eigentlich zur Konfiguration des zweiten Serialisierers in der Sensorvorrichtung vorgesehene Konfigurationsdatenstrom die Sensorvorrichtung nicht erreicht und die Empfangsvorrichtung statt des zweiten Serialisierers mittels des Konfigurationsdatenstroms den ersten Serialisierer konfiguriert. Die Empfangsvorrichtung kann eingerichtet sein, nach einem gescheiterten Konfigurationsversuch den Vorgang der Konfiguration des zweiten Serialisierers zu wiederholen, beispielsweise infolge eines ausbleibenden Bestätigungssignals vom zweiten Serialisierer. Deshalb ist die Aufzeichnungsvorrichtung besonders bevorzugt eingerichtet, solange, bis die Konfiguration des ersten Deserialisierers abgeschlossen und somit die Aufzeichnungsvorrichtung einsatzbereit ist, von der Empfangsvorrichtung wiederholt übertragene Konfigurationsdatenströme, insbesondere alle übertragenen Konfigurationsdatenströme, abzufangen.

Zur Einsatzbereitschaft des Gesamtsystems aus Sensorvorrichtung, Aufzeichnungsvorrichtung und Empfangsvorrichtung muss natürlich sichergestellt sein, dass final auch der zweite Serialisierer in der Sensorvorrichtung konfiguriert ist. Deshalb ist die Aufzeichnungsvorrichtung bevorzugt eingerichtet, nach Abschluss der Konfiguration des ersten Deserialisierers wiederholt übertragene Konfigurationsdatenströme von der Empfangsvorrichtung an die Sensorvorrichtung weiterzuleiten, um den zweiten Serialisierer einzurichten. Alternativ dazu kann die Aufzeichnungsvorrichtung auch eingerichtet sein, nach Abschluss der Konfiguration des ersten Deserialisierers den Mitschnitt der Konfigurationsdaten eigenständig über die erste Datenverbindung an die Sensorvorrichtung zu übertragen, statt auf einen neuen Konfigurationsdatenstrom von der Empfangsvorrichtung zu warten. Weiterhin bevorzugt ist die Aufzeichnungsvorrichtung eingerichtet, ein von der Sensorvorrichtung nach Abschluss der Konfiguration des zweiten Serialisierers übertragenes Bestätigungssignal zur Bestätigung einer Einsatzbereitschaft der Sensorvorrichtung an der ersten Datenschnittstelle aufzunehmen und an die Empfangsvorrichtung weiterzuleiten.

In der Empfangsvorrichtung ist im Regelfall ein zweiter Deserialisierer zur Deserialisierung des über die zweite Datenverbindung übertragenen Bilddatenstroms verbaut. Der zweite Deserialisierer kann eine mittels der zweiten Datenverbindung auslesbare Schnittstelle zum Auslesen einer bestehenden Konfiguration des zweiten Deserialisierers umfassen. Eine Kenntnis der aktuellen Konfiguration des zweiten Deserialisierers kann für die Ermittlung der Konfiguration des ersten Deserialisierers hilfreich oder sogar notwendig sein. Vorteilhaft ist die Konfigurationsvorrichtung deshalb eingerichtet, für die Analyse der Konfigurationsdaten die bestehende Konfiguration des zweiten Deserialisierers über die zweite Datenverbindung auszulesen und bei der Ermittlung der Konfiguration des ersten Deserialisierers zu berücksichtigen.

Neben der Konfiguration des zweiten Deserialisierers gibt es weitere Daten, deren Auswertung durch die Konfigurationsvorrichtung für die Ermittlung der Konfiguration des ersten Deserialisierers von Vorteil ist. Die Konfigurationsvorrichtung kann eingerichtet sein, zu diesem Zweck eine Netzliste zu berücksichtigen, die Datenverbindungen von Eingangspins des ersten Serialisierers zur Aufnahme von Bilddaten mit einer Anzahl interner Datenleitungen der Aufzeichnungsvorrichtung zur Übertragung von Bilddaten in die Eingangspins beschreibt. Nachdem die Konfigurationsvorrichtung ermittelt hat, wie der Bilddatenstrom auf die Eingangspins des ersten Serialisierers zu verteilen ist, kann die Konfigurationsvorrichtung anhand der Netzliste feststellen, wie die internen Datenleitungen der Aufzeichnungsvorrichtung mit ebendiesen Eingangspins verknüpft sind und auf Basis dieser Information die Konfiguration des ersten Deserialisierers so ausgestalten, dass der erste Deserialisierer die formatierten Bilddaten entsprechend auf die internen Datenleitungen verteilt, sodass die Bilddaten der ermittelten Verteilung entsprechend an den Eingangspins des ersten Serialisierers eintreffen.

Insbesondere, wenn in der Aufzeichnungsvorrichtung ein individueller erster Serialisierer verbaut ist, der derselben Baureihe wie der zweite Serialisierer angehört, ist die Netzliste eine wichtige Information, denn in dieser Ausgestaltung sind zwar die internen Datenleitungen der Aufzeichnungsvorrichtung nativ bekannt, nicht aber die Bilddaten-Eingangspins des ersten Serialisierers. Eine den ersten Serialisierer tragende austauschbare Platine muss in dieser Ausgestaltung eine Schnittstelle umfassen, welche die Eingangspins bzw. die in die Eingangspins mündenden elektrischen Datenleitungen der Platine mit den internen Datenleitungen der Aufzeichnungsvorrichtung verbindet. Diese Schnittstelle ist naturgemäß ebenso individuell wie der erste Serialisierer selbst, und nur anhand einer zugehörigen, die jeweilige Schnittstelle beschreibenden Netzliste kann die Konfigurationsvorrichtung feststellen, welche interne Datenleitung in welchen Eingangspin des ersten Serialisierers mündet.

Bevorzugt ist die Konfigurationsvorrichtung weiterhin eingerichtet, zur Ermittlung der Konfiguration des ersten Deserialisierers eine erste Abstrahierungsabbildung zu konsultieren. Die erste Abstrahierungsabbildung ist eine Zuordnung, die mögliche Konfigurationen des ersten Serialisierers (oder des zweiten Serialisierers - da beide gegeneinander austauschbar sind und der Konfigurationsdatenstrom auf beide Serialisierer anwendbar ist, ist es in technischer Hinsicht unerheblich, ob die Abstrahierungsabbildung formal dem ersten oder dem zweiten Serialisierer zugeordnet wird) technischen Funktionalitäten des ersten Serialisierers zuordnet, wobei unter einer Funktionalität einer Komponente jeweils eine Menge technischer Funktionen, zu deren Durchführung die jeweilige Komponente eingerichtet ist, zu verstehen ist. Mit anderen Worten umfasst die erste Abstrahierungsabbildung also für eine Vielzahl konkreter Konfigurationen des ersten Serialisierers jeweils eine detaillierte Beschreibung des technischen Verhaltens des ersten Serialisierers, das die jeweilige Konfiguration bewirkt. Vorteilhaft ist die erste Abstrahierungsabbildung vollständig, ist also so umfangreich ausgestaltet, dass sie jeder möglichen Konfiguration des ersten Serialisierers eine technische Funktionalität zuordnet. Die erste Abstrahierungsabbildung kann als eine Auflistung von Teilkonfigurationen ausgestaltet sein, die jeder Teilkonfiguration eine technische Funktion oder mehrere technische Funktionen zuordnet, sodass sich eine bestimmte Konfiguration des ersten Serialisierers als Summe von Teilkonfigurationen ergibt und die der bestimmten Konfiguration zugeordnete Funktionalität als Summe der den jeweiligen Teilkonfigurationen zugeordneten Funktionen. Unter einer Teilkonfiguration ist in einer möglichen Ausgestaltung eine mögliche Konfiguration einer Anzahl von Registern zu verstehen, die eine Untermenge aller zur Konfiguration des ersten Serialisierers vorgesehenen Register darstellt.

In dieser Ausgestaltung ist die Konfigurationsvorrichtung ausgestaltet, durch Anwendung der ersten Abstrahierungsabbildung auf die Konfiguration des ersten Serialisierers eine Funktionalität des ersten Serialisierers zu ermitteln. Anschließend konsultiert die Konfigurationsvorrichtung eine Kompatibilitätsabbildung, die möglichen Funktionalitäten des ersten Serialisierers jeweils eine Funktionalität des ersten Deserialisierers zuordnet. Auch die Kompatibilitätsabbildung ist vorzugsweise vollständig, ordnet also jeder möglichen Funktionalität des ersten Serialisierers jeweils eine Funktionalität des ersten Deserialisierers zu. Jede von der Kompatibilitätsabbildung zugeordnete Funktionalität des ersten Deserialisierers ist derart ausgestaltet, dass der die jeweilige Funktionalität ausführende erste Deserialisierer den Bilddatenstrom derart aufbereitet und auf die internen Datenleitungen der Aufzeichnungsvorrichtung verteilt, dass der erste Serialisierer die mittels der ersten Abstrahierungsabbildung ermittelte Funktionalität wie vorgesehen ausführen kann. Die Konfigurationsvorrichtung wendet die Kompatibilitätsabbildung auf die ermittelte Funktionalität des ersten Serialisierers an, um eine Funktionalität des ersten Deserialisierers zu ermitteln. Je nach Ausgestaltung der Erfindung kann diese Ermittlung einer Funktionalität des ersten Deserialisierers direkt, indirekt oder sowohl direkt als auch indirekt erfolgen.

Nach Ermittlung der Funktionalität des ersten Deserialisierers konsultiert die Konfigurationsvorrichtung eine erste Konkretisierungsabbildung, die Funktionalitäten des ersten Deserialisierers jeweils eine Konfiguration des ersten Deserialisierers zuordnet. Die Konfigurationsvorrichtung wendet die erste Konkretisierungsabbildung auf die ermittelte Funktionalität des ersten Deserialisierers an, ermittelt dadurch die Konfiguration des ersten Deserialisierers und konfiguriert den ersten Deserialisierer seiner ermittelten Konfiguration entsprechend.

Eine Kompatibilitätsabbildung kann in einer Ausgestaltung der Erfindung als eine Funktionalitätsabbildung ausgestaltet sein, die möglichen Funktionalitäten des ersten Serialisierers unmittelbar jeweils eine Funktionalität des ersten Deserialisierers zuordnet.

In einer anderen Ausgestaltung kann eine Kompatibilitätsabbildung eine zweite Abstrahierungsabbildung und eine zweite Konkretisierungsabbildung umfassen. Die zweite Abstrahierungsabbildung ordnet möglichen Funktionalitäten des ersten Serialisierers jeweils eine Spezifikation des Bilddatenstroms zu. Unter einer Spezifikation des Bilddatenstroms ist dabei eine anwendernahe Beschreibung der technischen Ausgestaltung der Bilddaten und des Bilddatenflusses zu verstehen, die aber keine konkreten Informationen über technische Mittel oder Maßnahmen zur Aufbereitung der Bilddaten bzw. zum Routing des Bilddatenflusses umfasst, um die Bilddaten und den Bilddatenfluss der Beschreibung entsprechend aufzuarbeiten. In der Spezifikation des Bilddatenstroms kann beispielsweise eine Quelladresse und eine Zieladresse direkt oder indirekt spezifiziert sein, aber keine Informationen darüber, über welche internen Ports oder Datenverbindungen die Bilddaten zu führen sind, um sie von der Quelladresse zu der Zieladresse zu übertragen. In der Spezifikation des Bilddatenstroms können beispielsweise einem Fachmann verständliche Kenngrößen für die Bilddaten und/oder den Bilddatenfluss spezifiziert sein, beispielsweise eine Übertragungsfrequenz oder eine Formatierung, aber keine Informationen über vorzunehmende Einstellungen, um die Bilddaten gemäß den Spezifikationen einzurichten. Die zweite Konkretisierungsabbildung ordnet möglichen Spezifikationen der Bilddaten jeweils eine Funktionalität des ersten Deserialisierers zu, wobei jede von der zweiten Konkretisierungsabbildung zugeordnete Funktionalität derart ausgestaltet ist, dass der erste Deserialisierer die Bilddaten derart aufbereitet und auf die internen Datenleitungen der Aufzeichnungsvorrichtung verteilt, dass der vom ersten Deserialisierer ausgegebene Bilddatenstrom die ermittelte Spezifikation des Bilddatenstroms erfüllt. Weiterhin ist jede von der zweiten Konkretisierungsabbildung zugeordnete Funktionalität derart ausgestaltet, dass der erste Deserialisierer einen die ermittelte Spezifikation erfüllende Bilddatenstrom gemäß der ermittelten Funktionalität aufnehmen und aufbereiten kann.

Zusammengefasst ist die Aufzeichnungsvorrichtung in einer vorteilhaften Ausgestaltung also eingerichtet, mittels zumindest einer speziellen Abstrahierungsabbildung eine durch den Konfigurationsdatenstrom vorgegebene Konfiguration des ersten Serialisierers in eine abstraktere, anwendernähere technische Beschreibung der Funktionalität des ersten Serialisierers zu übersetzen, anschließend aus zumindest einer speziellen Kompatibilitätsabbildung eine auf einem ähnlichen Abstraktionsniveau angesiedelte technische Beschreibung einer Funktionalität des ersten Deserialisierers auszulesen, die den ersten Deserialisierer einrichtet, den Bilddatenstrom derart aufzubereiten und auf die Eingangspins des ersten Serialisierers zu verteilen, dass der erste Serialisierer seine technische Funktionalität wie vorgesehen ausführen kann, und final mittels einer speziellen Konkretisierungsabbildung die technische Funktionalität des ersten Deserialisierers in eine Konfiguration des ersten Deserialisierers zu übersetzen.

Im OSI-Referenzmodell (Open Systems Interconnection model) bedeutet das, dass die erste Abstrahierungsabbildung eine konkrete Konfiguration, insbesondere eine Registersetzung, in eine technische Beschreibung der konkreten Konfiguration in einer höheren Schicht übersetzt, insbesondere in einer oder mehrerer der Schichten 2 bis 5. Die zweite Abstrahierungsabbildung übersetzt die technische Beschreibung aus der ersten Abstrahierungsabbildung in eine weitere technische Beschreibung in einer noch höheren, anwendernäheren Schicht, insbesondere in einer oder beider der Schichten 6 und 7. Die zweite Konkretisierungsabbildung übersetzt die aus der zweiten Abstrahierungsabbildung hervorgegangene technische Beschreibung in eine Auflistung von technischen Funktionen des ersten Deserialisierers. Diese Auflistung von technischen Funktionen ist eine technische Beschreibung einer Funktionalität des ersten Deserialisierers, die im OSI-Referenzmodell wieder in mindestens einer der tieferen, hardwarenäheren Schichten eingeordnet ist, insbesondere in einer oder mehrerer der Schichten 2 bis 5. Die erste Konkretisierungsabbildung konkretisiert die vorhandene Information über die Funktionalität des ersten Deserialisierers in eine konkrete Konfiguration, insbesondere Registersetzung, des ersten Deserialisierers.

Die Erfindung wird nachfolgend anhand der Zeichnungen näher erläutert. Die Zeichnungen und deren nachfolgende Beschreibungen illustrieren in schematischer Weise eine beispielhafte Ausgestaltung der Erfindung. Es zeigen
- Figur 1: einen typischen Aufbau mit einer Sensorvorrichtung, einer erfindungsgemäßen Aufzeichnungsvorrichtung und einer Empfangsvorrichtung;
- Figur 2: die Herleitung einer Konfiguration des ersten Deserialisierers in einer ersten Ausführungsform;
- Figur 3: die Herleitung einer Konfiguration des ersten Deserialisierers in einer zweiten Ausführungsform;
- Figur 4: die Herleitung einer Konfiguration des ersten Deserialisierers in einer dritten Ausführungsform;
- Figur 5: eine beispielhafte Netzliste; und
- Figur 6: einen zeitlichen Ablauf des erfindungsgemäßen Konfigurationsvorgangs.

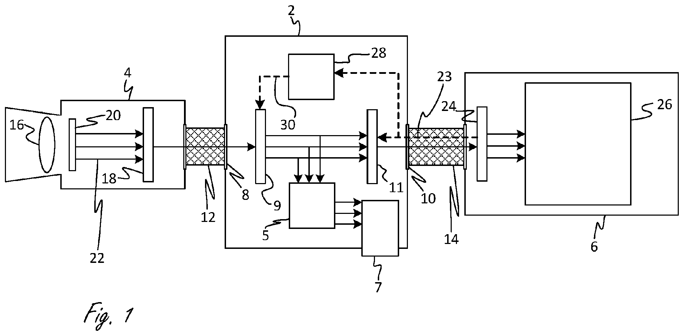

Die Abbildung der Figur 1 zeigt eine Aufzeichnungsvorrichtung 2 mit einer ersten Datenschnittstelle 8, einer zweiten Datenschnittstelle 10, einem ersten Serialisierer 11 und einem ersten Deserialisierer 9. Eine an der ersten Datenschnittstelle 8 anliegende erste Datenverbindung 12 verbindet die Aufzeichnungsvorrichtung 2 mit einer Sensorvorrichtung 4, und eine an der zweiten Datenschnittstelle 10 anliegende zweite Datenverbindung 14 verbindet die Aufzeichnungsvorrichtung 2 mit einer Empfangsvorrichtung 6. Die Sensorvorrichtung 4 ist eine abbildende Sensorvorrichtung und kann beispielsweise als Kamera, Infrarotkamera, LIDAR (Light Detection and Ranging) oder RADAR (Radio Detection and Ranging) ausgestaltet sein.

Die Sensorvorrichtung 4 umfasst ein Abbildungssystem 16, beispielsweise eine Kameraoptik, zur Abbildung eines elektromagnetischen Feldes auf eine Bildebene und einen an der Bildebene angeordneten Sensor 20 zur Rekonstruktion eines digital kodierten Abbildes der Umgebung der Sensorvorrichtung 4 aus dem elektromagnetischen Feld. Der Sensor 20 ist eingerichtet, das elektromagnetische Feld kontinuierlich in Bilddatenframes zu übersetzen, von denen jeder eine Momentaufnahme der Umgebung der Sensorvorrichtung darstellt, und die Bilddatenframes kontinuierlich als Bilddatenstrom 22 über interne Datenleitungen der Sensorvorrichtung 4 zu verschicken. Der Bilddatenstrom 22 ist in der gesamten Abbildung der Figur 1 als durchgezogene Pfeile dargestellt. Ein zweiter Serialisierer 18 ist in der Sensorvorrichtung 4 angeordnet, um den Bilddatenstrom 22 aufzunehmen, zu serialisieren und den serialisierten Bilddatenstrom 22 auf die erste Datenverbindung 12 auszugeben.

In der Empfangsvorrichtung 6 ist ein zweiter Deserialisierer 24 angeordnet, um den Bilddatenstrom 22 von der zweiten Datenverbindung 14 aufzunehmen, zu deserialisieren und den deserialisierten Bilddatenstrom 22 über interne Datenleitungen der Empfangsvorrichtung 6 an eine Prozessoreinheit 26 der Empfangsvorrichtung 6 weiterzuleiten. Die Empfangsvorrichtung 6 kann beispielsweise als Steuergerät ausgestaltet sein, auf der Prozessoreinheit 26 kann eine Perzeptionsroutine zur Erkennung und Klassifizierung von Objekten in dem Bilddatenstrom 22 eingerichtet sein, und weiterhin eine Entscheidungsroutine zur Generierung von Steuerbefehlen auf Basis der klassifizierten Objekte.

Die Aufzeichnungsvorrichtung 2 ist zwischen der Sensorvorrichtung 4 und der Empfangsvorrichtung 6 angeordnet, um den von der Sensorvorrichtung 4 ausgegebenen Bilddatenstrom 22 mitzuschneiden. Um eine ordnungsgemäße Funktion sowohl der Sensorvorrichtung 4 als auch der Empfangsvorrichtung 6 zu gewährleisten, ist die Aufzeichnungsvorrichtung 2 als Man in the middle ausgestaltet. Das bedeutet, dass die Aufzeichnungsvorrichtung 2, obwohl sämtliche zwischen der Sensorvorrichtung 4 und der Empfangsvorrichtung 6 ausgetauschten Daten durch die Aufzeichnungsvorrichtung 2 fließen, sich weder gegenüber der Sensorvorrichtung 4 noch gegenüber der Empfangsvorrichtung 6 zu erkennen gibt. Im Regelbetrieb täuscht die Aufzeichnungsvorrichtung 2 der Empfangsvorrichtung 6 vor, unmittelbar mit der Sensorvorrichtung 4 zu kommunizieren, und sie täuscht der der Sensorvorrichtung 4 vor, unmittelbar mit der Empfangsvorrichtung 6 zu kommunizieren. Aus Sicht der Sensorvorrichtung 4 und der Empfangsvorrichtung 6 stellen sich die erste Datenverbindung 12 und die zweite Datenverbindung 14 als eine einzige, unmittelbare Datenverbindung da.

Der erste Deserialisierer 9 ist angeordnet und eingerichtet, um den serialisierten Bilddatenstrom 22 von der ersten Datenschnittstelle 8 aufzunehmen, zu deserialisieren und den deserialisierten Bilddatenstrom 22 über interne Datenleitungen L1, ..., L10 der Aufzeichnungsvorrichtung 2 an den ersten Serialisierer 11 weiterzuleiten. Die Aufzeichnungsvorrichtung 2 umfasst eine Speichervorrichtung 5, die eingerichtet ist, den vom ersten Deserialisierer 9 deserialisierten Datenstrom mitzuschneiden und den Mittschnitt des Bilddatenstroms 22 auf einem in ein Laufwerk der Aufzeichnungsvorrichtung eingeschobenen Datenträger 7 zu speichern.

Der erste Serialisierer 11 ist angeordnet und eingerichtet, um den deserialisierten und von der Speichervorrichtung 5 mitgeschnittenen Bilddatenstrom 22 vom ersten Deserialisierer 9 aufzunehmen, wieder zu serialisieren und über die zweite Datenschnittstelle 10 auszugeben und auf die zweite Datenverbindung 14 zu leiten.

Serialisierer und Deserialisierer sind, im Normalfall durch Registersetzung, hinsichtlich ihrer technischen Funktionalität konfigurierbar. Im Regelbetrieb, d.h. wenn Sensorvorrichtung 4 und Empfangsvorrichtung 6 ohne Anwesenheit der Aufzeichnungsvorrichtung 2 direkt miteinander kommunizieren, konfiguriert die Empfangsvorrichtung 6 während des Hochfahrens den zweiten Deserialisierer 24 und versendet einen Konfigurationsdatenstrom 23 zur Konfiguration des zweiten Serialisierers 18 in der Sensorvorrichtung 4. Konfigurationsdatenströme zur Konfiguration von Serialisierern oder Deserialisierern sind in der gesamten Abbildung der Figur 1 als gestrichelte Pfeile dargestellt.

Der Konfigurationsdatenstrom 23 definiert eine Konfiguration bzw. eine Registersetzung des zweiten Serialisierers 18, und die Sensorvorrichtung 4 ist ausgestaltet, um den Konfigurationsdatenstrom 23 aufzunehmen und den zweiten Serialisierer 18 gemäß der Vorgabe des Konfigurationsdatenstroms zu konfigurieren. Der Konfigurationsdatenstrom 23 kann von dem zweiten Deserialisierer 24 selbst oder von einer anderen Komponente der Empfangsvorrichtung 6 erzeugt werden. Ebenso kann auf Seiten der Sensorvorrichtung 4 der zweite Serialisierer 18 den Konfigurationsdatenstrom 23 selbst aufnehmen und sich selbst gemäß dessen Vorgabe konfigurieren, oder eine andere Komponente der Sensorvorrichtung 4 kann den Konfigurationsdatenstrom 23 aufnehmen und den zweiten Serialisierer 18 konfigurieren.

Der erste Serialisierer 11 gehört derselben Baureihe an wie der zweite Serialisierer 18. Beide sind also hinsichtlich ihrer technischen Ausstattung und ihres technischen Designs identisch und gegeneinander austauschbar. Infolgedessen ist der Konfigurationsdatenstrom 23 unmittelbar zur Konfiguration des ersten Serialisierers 11 verwendbar, und die Aufzeichnungsvorrichtung 2 ist eingerichtet, um den eigentlich für den zweiten Serialisierer 18 vorgesehenen Konfigurationsdatenstrom 23 abzufangen und mittels des Konfigurationsdatenstroms 23 den ersten Serialisierer 11 zu konfigurieren.

Die technische Funktionalität des ersten Serialisierers 11 entspricht damit genau der vorgesehenen technischen Funktionalität des zweiten Serialisierers 18, da beide Serialisierer baugleich sind und der erste Serialisierer 11 mit dem für den zweiten Serialisierer 18 vorgesehenen Konfigurationsdatenstrom 23 konfiguriert wurde. Der erste Deserialisierer 9 muss konfiguriert werden, den von der Sensorvorrichtung 4 zugelieferten Bilddatenstrom 22 derart aufzubereiten und auf die internen Datenleitungen der Aufzeichnungsvorrichtung 2 bzw. auf die Eingangspins des ersten Serialisierers 11 zu verteilen, dass der erste Serialisierer 11 seine durch den Konfigurationsdatenstrom 23 vorgegebene technische Funktionalität wie vorgesehen ausführen kann. Letztlich muss der erste Deserialisierer konfiguriert werden, um die vom zweiten Serialisierer 18 vorgenommene Serialisierung des Bilddatenstroms 22 rückgängig zu machen und den vom Sensor 20 ausgegebenen Bilddatenstrom zu rekonstruieren. Anders als die Konfiguration des ersten Serialisierers 11 ist diese Konfiguration des ersten Deserialisierers 9 nicht unmittelbar durchführbar, weil die Empfangsvorrichtung 6 keinen dafür geeigneten Konfigurationsdatenstrom bereitstellt.

Für die Ermittlung und Durchführung einer solchen Konfiguration des ersten Deserialisierers 9 umfasst die Aufzeichnungsvorrichtung 2 eine Konfigurationsvorrichtung 28, die eingerichtet ist, den Konfigurationsdatenstrom 23 mitzuschneiden und den Mitschnitt der Konfigurationsdaten zu analysieren. (Falls der Konfigurationsdatenstrom 23 gemäß der Lehre der DE 10 2019 132 476 A1 in einen anderen Konfigurationsdatenstrom umgewandelt wird, schneidet die Konfigurationsvorrichtung 28 an dieser Stelle den umgewandelten Konfigurationsdatenstrom mit.) Mittels der als Ergebnis der Analyse gewonnenen Informationen ermittelt die Konfigurationsvorrichtung 28 eine Konfiguration des ersten Deserialisierers 9, die den ersten Deserialisierer 9 einrichtet, die Bilddaten aus dem Bilddatenstrom auf die korrekte, vom konfigurierten ersten Serialisierer 11 erwartete Weise zu formatieren und auf die Eingangspins des ersten Serialisierers 11 zu verteilen. Nach Abschluss der Ermittlung erstellt die Konfigurationsvorrichtung 28 einen Deserialisierer-Konfigurationsdatenstrom 30, der geeignet ist, den ersten Deserialisierer 9 wie in der Analyse ermittelt zu konfigurieren, und konfiguriert den ersten Deserialisierer 9 mittels des Deserialisierer-Konfigurationsdatenstroms 30.

Auch wenn in der Abbildung der Figur 1 die Konfigurationsvorrichtung 28 als eine integrale Komponente der Aufzeichnungsvorrichtung 2 dargestellt ist, kann die Konfigurationsvorrichtung 28 ebenso gut außerhalb der Aufzeichnungsvorrichtung 2 angeordnet sein, auch als virtuelle Komponente, z.B. in Form einer auf einem Personal Computer (PC) hinterlegten Software. Die Übertragung des Konfigurationsdatenstroms 23 sowie des Deserialisierer-Konfigurationsdatenstroms 30 kann in diesem Fall über eine geeignete Datenschnittstelle, beispielsweise ein USB-Kabel oder eine drahtlose Datenverbindung wie WLAN oder Bluetooth erfolgen. Die Konfigurationsvorrichtung 28 kann auch in Form eines über das Internet kontaktierbaren Servers ausgestaltet sein, sodass der gesamte Konfigurationsvorgang in Form eines Firmware Updates der Aufzeichnungsvorrichtung 2 abläuft.

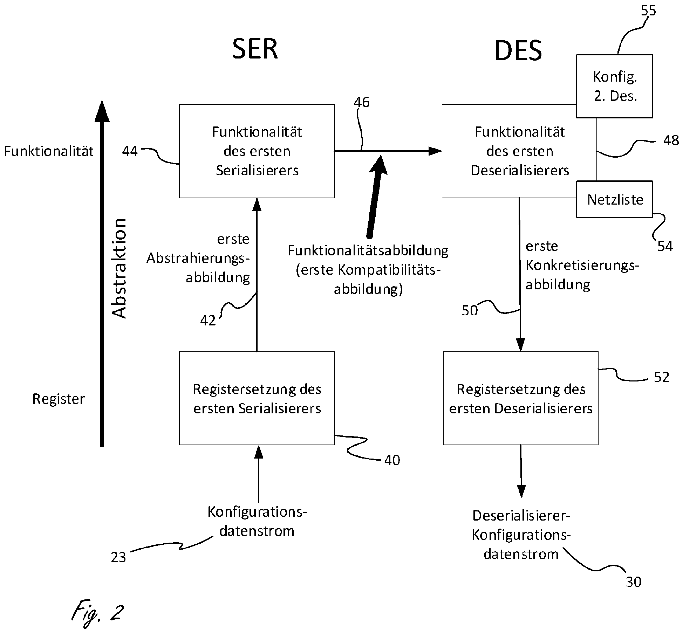

Die Abbildungen der Figuren 2 bis 4 erläutern in Form von Ablaufdiagrammen die von der Konfigurationsvorrichtung 28 vorgenommenen Schritte zur Herleitung der Konfiguration des ersten Deserialisierers 9. Jede der drei Figuren 2 bis 4 zeigt dabei eine von drei möglichen Ausgestaltungen der automatisierten Herleitung der Konfiguration des ersten Deserialisierers 9 durch die Konfigurationsvorrichtung 28. Schritte, die sich auf den ersten Serialisierer 11 beziehen, sind jeweils auf der linken Seite des Diagramms unter der Überschrift "SER" angeordnet. Schritte, die sich auf den ersten Deserialisierer 9 beziehen, sind jeweils auf der rechten Seite des Diagramms unter der Überschrift "DES" angeordnet.

Wie in der Abbildung der Figur 2 dargestellt, besteht der erste Schritt in der Ermittlung der konkreten Konfiguration des ersten Serialisierers 11. Unter der Annahme, dass die Konfiguration des ersten Serialisierers 11 durch eine Registersetzung des ersten Serialisierers 11 festgelegt ist, entspricht die konkrete Konfiguration einer konkreten Registersetzung 40 des ersten Serialisierers 11. Wie in der Beschreibung der Figur 1 bereits erläutert, liefert die Empfangsvorrichtung die Registersetzung 40 des ersten Serialisierers 11 in Form des Konfigurationsdatenstroms 23 unmittelbar zu, und die Konfigurationsvorrichtung 28 liest die Registersetzung 40 unmittelbar aus dem Mittschnitt des Konfigurationsdatenstroms 23 aus.

Im zweiten Schritt konsultiert die Konfigurationsvorrichtung 28 eine erste Abstrahierungsabbildung 42, um anhand der ersten Abstrahierungsabbildung 42 aus der Registersetzung 40 des ersten Serialisierers 11 eine Funktionalität 44 des ersten Serialisierers 11 herzuleiten. Die erste Abstrahierungsabbildung 42 ist im Grunde eine tabellarische Übersicht, die Registersetzungen des ersten Serialisierers 11 technischen Funktionalitäten des ersten Serialisierers 11 gegenüberstellt und hinreichend umfangreich ist, dass für jede mögliche Registersetzung des ersten Serialisierers 11 eine aus der jeweiligen Registersetzung resultierende Funktionalität des ersten Serialisierers auslesbar ist. Vorteilhaft listet die erste Abstrahierungsabbildung 42 Setzungen von Einzelregistern oder Teilregistersetzungen, d.h. Setzungen kleiner Gruppen von Registern, auf, und ordnet jeder Einzelregistersetzung und/oder jeder Teilregistersetzung eine Funktion oder eine Teilfunktionalität des ersten Serialisierers 11 zu, sodass sich die Funktionalität 44 des ersten Serialisierers 11 als Gesamtheit von Funktionen und/oder Teilfunktionalitäten ergibt.

Die Funktionalität 44 des ersten Serialisierers 11 ist eine Auflistung technischer Funktionen des ersten Serialisierers 11, die sich aus der Registersetzung 40 des ersten Serialisierers ergibt, aber keinen Bezug zum Modell oder zur Baureihe des ersten Serialisierers 11 und insbesondere keinen Bezug auf konkrete Teilkonfigurationen des ersten Serialisierers 40 mehr aufweist.

Nach Herleitung der Funktionalität 44 des ersten Serialisierers 11 konsultiert die Konfigurationsvorrichtung 28 eine erste Kompatibilitätsabbildung 46, um anhand der ersten Kompatibilitätsabbildung 46 aus der Funktionalität 44 des ersten Serialisierers 11 eine Funktionalität 48 des ersten Deserialisierers herzuleiten. Eine Kompatibilitätsabbildung ist eine Abbildung, die möglichen Funktionen und/oder Teilfunktionalitäten des ersten Serialisierers 11 Funktionen und/oder Teilfunktionalitäten des ersten Deserialisierers 9 zuordnet, die der erste Deserialisierer 9 aufweisen muss, damit zum einen der Speichervorrichtung 5 ein sinnvoller, interpretierbarer Bilddatenstrom 23, entsprechend dem vom Sensor 20 ausgegebenen Bilddatenstrom 23, zur Verfügung steht und zum anderen der erste Serialisierer 9 die jeweilige Funktion bzw. Teilfunktionalität ordnungsgemäß ausführen kann.

Als willkürliches Beispiel in der Funktionalität 44 des ersten Serialisierers 11 eine Reihenfolge vorgegeben sein, in welcher der erste Serialisierer 11 bzw. der zweite Serialisierer 18 die Bilddaten in dem serialisierten Bilddatenstrom ausgeben. Diese Reihenfolge muss der erste Deserialisierer natürlich beachten, um aus dem über die erste Datenverbindung 12 zugelieferten Bilddatenstrom einen sinnvollen, auslesbaren Strom von Bilddatenframes zu rekonstruieren. Passend zu der durch den Konfigurationsdatenstrom 23 vorgegebenen Reihenfolge ermittelt die Konfigurationsvorrichtung 28 eine Konfiguration des ersten Deserialisierers 9, die den ersten Deserialisierer 9 einrichtet, eine in eben dieser Reihenfolge vorgenommene Serialisierung des Bilddatenstroms 23 rückgängig zu machen, um aus dem serialisierten Bilddatenstrom 23 wieder die ursprünglichen Bilddatenframes zu rekonstruieren, wie sie der Sensor 18 ausgegeben hat.

Die erste Kompatibilitätsabbildung 46 ist als Funktionalitätsabbildung ausgestaltet, d.h. als tabellarische Zuordnung, die Funktionen und/oder Teilfunktionalitäten und/oder Funktionalitäten des des ersten Serialisierers 44 unmittelbar Funktionen und/oder Teilfunktionalitäten und/oder Funktionalitäten des ersten Deserialisierers zuordnet, sodass mittels der ersten Kompatibilitätsabbildung 46 aus der Funktionalität 46 des ersten Serialisierers 11 unmittelbar eine Funktionalität 48 des ersten Deserialisierers herleitbar ist. Die Funktionalität 48 des ersten Deserialisierers 9 ist auf demselben Abstraktionsniveau beschrieben wie die Funktionalität 44 des ersten Serialisierers 11, d.h. sie umfasst eine Auflistung technischer Funktionen und/oder Teilfunktionalitäten ohne Bezug zu einer bestimmten Deserialisierer-Baureihe, einem bestimmten Deserialisierer-Modell oder konkreten Teilkonfigurationen des ersten Deserialisierers 9.

Aus der Funktionalität 48 des ersten Deserialisierers 9 leitet die Konfigurationsvorrichtung 28 schließlich eine konkrete Konfiguration, d.h. eine konkrete Registersetzung 52, des ersten Deserialisierers 9 her und konsultiert dafür eine erste Konkretisierungsabbildung 50. Die erste Konkretisierungsabbildung 50 ist inhaltlich analog zur ersten Abstrahierungsabbildung 42, d.h. sie ordnet Registern und/oder Teilregistersetzungen des ersten Deserialisierers 9 in tabellarischer Form Funktionen und/oder Teilfunktionalitäten des ersten Deserialisierers 9 zu, aber die Konfigurationsvorrichtung 28 verwendet sie in umgekehrter Reihenfolge. Nach Ermittlung der Registersetzung 52 erstellt die Konfigurationsvorrichtung 28 den Deserialisierer-Konfigurationsdatenstrom 30 derart, dass der Deserialisierer-Konfigurationsdatenstrom 30 die Register des ersten Deserialisierers 9 gemäß der ermittelten Registersetzung 52 des ersten Deserialisierers einrichtet, und konfiguriert den ersten Deserialisierer 9 mittels des Deserialisierer-Konfigurationsdatenstroms 30.

Sofern der zweite Deserialisierer 24 diese Funktion unterstützt, liest die Konfigurationsvorrichtung 28 über die zweite Datenverbindung 14 die Konfiguration 55 des zweiten Deserialisierers 24 aus und berücksichtigt die Konfiguration 55 des zweiten Deserialisierers 24 bei der Ermittlung der Registersetzung 52 des ersten Deserialisierers 9. Da der erste Deserialisierer 9 und der zweite Deserialisierer 24 einen gleichartig serialisierten Bilddatenstrom 22 verarbeiten, ist die Wahrscheinlichkeit hoch, dass sich einige Konfigurationsmerkmale des zweiten Deserialisierers 24 unverändert auf den ersten Deserialisierer 9 übertragen lassen.

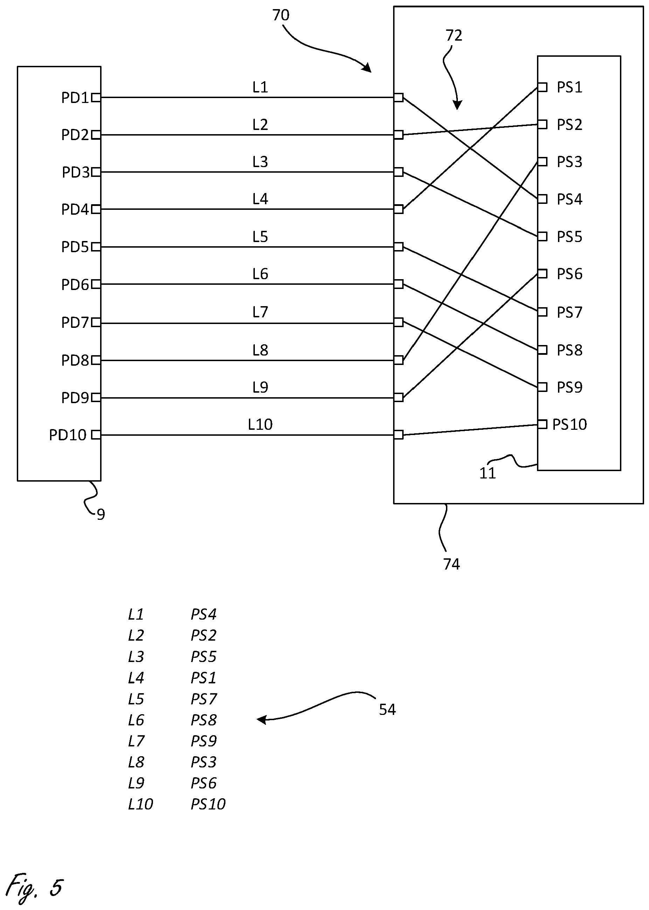

Bei der Herleitung der Registersetzung 52 des ersten Deserialisierers 9 anhand der ersten Konkretisierungsabbildung 50 konsultiert die Konfigurationsvorrichtung 28 zusätzlich eine Netzliste 54, die Eingangspins PS1, ..., PS10 des ersten Serialisierers mit internen Datenleitungen L1, ..., L10 der Aufzeichnungsvorrichtung 2 in Beziehung setzt. Die Netzliste 54 ist in der Abbildung der Figur 5 erläutert. Wie zuvor erläutert, muss der erste Serialisierer 11 die Funktionalität des zweiten Serialisierers 18 emulieren und gehört deshalb vorteilhaft derselben Baureihe an wie der wie der zweite Serialisierer 18. In der Folge wird der erste Serialisierer 11 kundenindividuell verbaut und ist deshalb auf einer auswechselbaren Platine 74 angeordnet. Die Ausgangspins PD1, ..., PD10 des ersten Deserialisierers 9, auf denen der erste Deserialisierer 9 den deserialisierten Bilddatenstrom 22 ausgibt, führen auf interne Datenleitungen L1, ..., L10 der Aufzeichnungsvorrichtung 2. Die internen Datenleitungen L1, ..., L10 wiederum münden in eine Schnittstelle 70 der Platine 74. Die Schnittstelle 70 stellt für jede interne Datenleitung L1, ..., L10 einen Eingang bereit, und die Eingänge sind über elektrische Verbindungen 72 in der Platine 74 mit den Eingangspins PS1, ..., PS10 des ersten Serialisierers 11 verbunden. Auf diese Weise ist für jeden benötigten Ausgangspin PD1, ..., PD10 des ersten Deserialisierers 9 eine Datenverbindung zu einem Eingangspin PS1, ..., PS10 des ersten Serialisierers 11 zur Übertragung von Bilddaten vom ersten Deserialisierer 9 zum ersten Serialisierer 11 eingerichtet. Welche Datenleitung L1, ..., L10 in welchen Eingangspin PS1, ..., PS10 mündet, ist aber natürlich von der Baureihe des ersten Serialisierers 11 und von der Einrichtung der elektrischen Verbindungen 72 abhängig. Diese Information benötigt die Konfigurationsvorrichtung 28 zur Ermittlung der Registersetzung 52 des ersten Deserialisierers und entnimmt sie der Netzliste 54. Die Netzliste 54 ist eine tabellarische Zuordnung, der entnehmbar ist, welche Datenleitung L1, ..., L10 bzw. welcher Ausgangspin PD1, ..., PD10 mit welchem Eingangspin PS1, ..., PS10 verbunden ist.

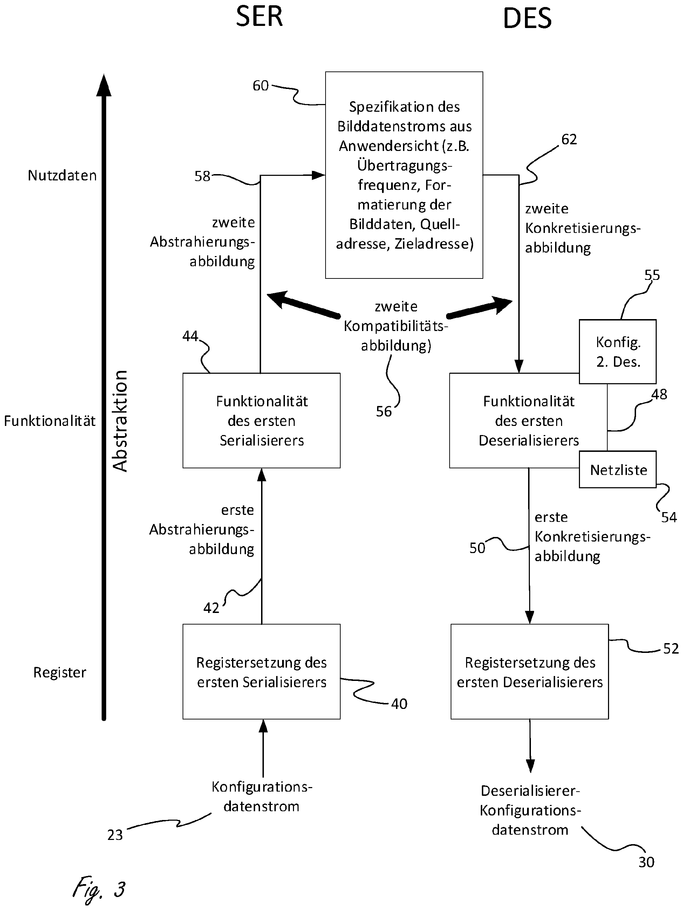

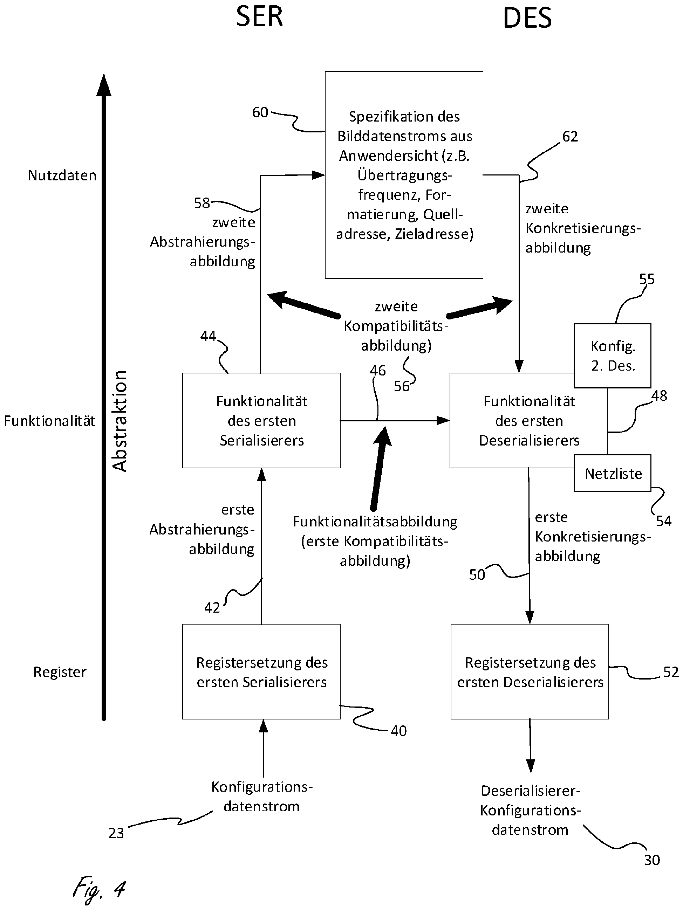

Die Figuren 3 und 4 zeigen alternative Ausführungsformen der automatisierten Herleitung der Registersetzung 52 des ersten Deserialisierers 9. In den nachfolgenden Beschreibungen werden nur die Unterschiede zur Figur 2 erläutert.

Die Abbildung der Figur 3 zeigt einen Ablauf, in dem die erste Kompatibilitätsabbildung 46 durch eine zweischrittige zweite Kompatibilitätsabbildung 56 ersetzt ist und durch die zweite Kompatibilitätsabbildung 56 eine weitere Abstrahierungsstufe eingeführt ist. Die zweite Kompatibilitätsabbildung 56 umfasst eine zweite Abstrahierungsabbildung 58, die als tabellarische Übersicht möglichen Funktionalitäten des ersten Serialisierers 11 Spezifikationen des Bilddatenstroms 22 zuordnet. Die Konfigurationsvorrichtung 28 konsultiert die zweite Abstrahierungsabbildung 58, um anhand der zweiten Abstrahierungsabbildung aus der Funktionalität 44 des ersten Serialisierers 11 eine Spezifikation 60 des Bilddatenstroms 22 herzuleiten. Diese Spezifikation 60 ist eine technische Beschreibung des Bilddatenstroms 60 aus Anwendersicht. Sie umfasst allgemeine Kenngrößen des Bilddatenstroms, aber keine Informationen über technische Maßnahmen oder Einstellungen der an der Übertragung des Bilddatenstroms 22 beteiligten Hardware, insbesondere über die Funktionalitäten 44, 48 des ersten Serialisierers 11 oder des ersten Deserialisierers 9. Sie ist damit auf einem noch höheren Abstraktionsniveau als die beiden Beschreibungen 44, 48 der Funktionalitäten angesiedelt und lässt sich weder dem ersten Serialisierer 44 noch dem ersten Deserialisierer 48 eindeutig zuordnen. Mögliche Beispiele für in der Spezifikation des Bilddatenstroms spezifizierte Kenngrößen sind Übertragungsfrequenz, Formatierung der Bilddaten sowie eine Quelladresse oder eine Zieladresse des Bilddatenstroms.

Weiterhin umfasst die zweite Kompatibilitätsabbildung 56 eine zweite Konkretisierungsabbildung 62. Die Konfigurationsvorrichtung 28 konsultiert die zweite Konkretisierungsabbildung 62, um aus der Spezifikation 60 des Bilddatenstroms 22 die Funktionalität 48 des ersten Deserialisierers herzuleiten. Die zweite Konkretisierungsabbildung 62 ist inhaltlich analog zur zweiten Abstrahierungsabbildung58, d.h. sie ordnet Funktionalitäten des ersten Deserialisierers 9 Spezifikationen des Bilddatenstroms 22 zu, die sich aus eben diesen Funktionalitäten ergeben, aber die Konfigurationsvorrichtung 28 verwendet sie in umgekehrter Reihenfolge. Nach Erstellung der Spezifikation 60 des Bilddatenstroms 22 wendet die Konfigurationsvorrichtung 28 die zweite Konkretisierungsabbildung 62 auf die Spezifikation 60 an, um aus der zweiten Konkretisierungsabbildung auszulesen, welche Funktionalität der erste Deserialisierer 9 aufweisen muss, um einen eben diese Spezifikationen erfüllenden Bilddatenstrom 22 zu erzeugen.

Die Abbildung der Figur 4 zeigt eine kombinierte Ausführungsform, in der die Konfigurationsvorrichtung 28 zur Herleitung der Funktionalität 48 des ersten Deserialisierers 9 sowohl auf die erste Kompatibilitätsabbildung 56 als auch auf die zweite Kompatibilitätsabbildung 60 zurückgreift. Die ermittelte Funktionalität 48 des ersten Deserialisierers ergibt sich in dieser Ausführung als die Vereinigungsmenge der mittels der ersten Kompatibilitätsabbildung 46 und der mittels der zweiten Kompatibilitätsabbildung 56 hergeleiteten Funktionen und/oder Teilfunktionalitäten des ersten Deserialisierers 9.

Es versteht sich von selbst, dass die Konfigurationsvorrichtung 28 zur Durchführung der vorhergehend beschriebenen Schritte Zugriff auf die dafür benötigten benötigten Informationen, d.h. auf die Abstrahierungsabbildungen 42, 58, die Konkretisierungsabbildungen 62, 50, die Netzliste 54 und eventuell die Funktionalitätsabbildung 46 benötigt. Vorteilhaft wird eine Datenbank mit einer Vielzahl von Abstrahierungsabbildungen 42, 58, Netzlisten 54 und eventuell Kompatibilitätsabbildungen 46 vorgehalten, um für eine Vielzahl möglicher Baureihen des ersten Serialisierers 11 eine erfindungsgemäße automatische Konfiguration des ersten Deserialisierers 9 durchführen zu können. Da in dem vorgestellten Ausführungsbeispiel eine einheitliche Baureihe des ersten Deserialisierers 9 vorgesehen ist, ist es nicht notwendig, unterschiedliche Ausführungen der ersten Konkretisierungsabbildung 50 und der zweiten Konkretisierungsabbildung 62 vorzuhalten. Bei Bedarf ist es aber natürlich ebenso möglich, die Datenbank um eine Vielzahl von Konkretisierungsabbildungen 50, 62 für unterschiedliche Baureihen des ersten Deserialisierers 9 zu erweitern. Die zum ersten Serialisierer 11 passenden Informationen (zumindest erste Abstrahierungsabbildung 42 und Netzliste 54, bei Bedarf zweite Abstrahierungsabbildung 58 und/oder Kompatibilitätsabbildung 56) müssen auf einem durch die Konfigurationsvorrichtung 28 auslesbaren Speichermedium hinterlegt sein.

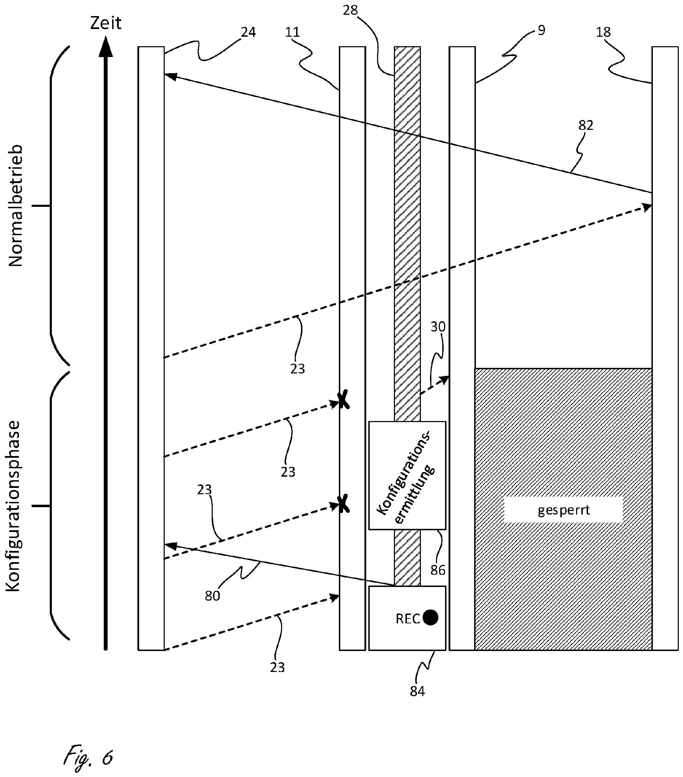

In der Abbildung der Figur 6 sind die Signalflüsse und die von der Konfigurationsvorrichtung 28 durchgeführten Arbeitsschritte auf einer Zeitachse dargestellt. Zu Anfang (ganz unten auf der Zeitachse), d.h. nach Einschalten der Aufzeichnungsvorrichtung 2, geht die Aufzeichnungsvorrichtung 2 zunächst in eine Konfigurationsphase. Während der Konfigurationsphase blockiert die Aufzeichnungsvorrichtung 2 den Datenfluss auf der zweiten Datenverbindung 14, sodass keine Kommunikation zwischen dem zweiten Deserialisierer 24 und dem zweiten Serialisierer 18 möglich ist. Die Aufzeichnungsvorrichtung 2 versetzt die Konfigurationsvorrichtung 28 zunächst in einen Aufnahmemodus 84, innerhalb dessen die Konfigurationsvorrichtung 28 auf den Konfigurationsdatenstrom 23 wartet. Nach Einschalten der Empfangsvorrichtung 6 übermittelt der zweite Deserialisierer 24 den Konfigurationsdatenstrom 23, um den zweiten Serialisierer 18 zu konfigurieren. Die Aufzeichnungsvorrichtung 2 fängt den Konfigurationsdatenstrom 23 derart ab, dass die Empfangsvorrichtung 6 statt des zweiten Serialisierers 18 den ersten Serialisierer 11 konfiguriert. Der zweite Serialisierer 18 bleibt vorerst unkonfiguriert. die Konfigurationsvorrichtung 28 legt einen Mittschnitt des Konfigurationsdatenstroms 23 an, speichert den Mittschnitt ab und beendet die Aufnahmephase 84.

Der zweite Deserialisierer 24 erwartet nach Übermittlung des Konfigurationsdatenstroms 23 von der Sensorvorrichtung 4 ein Bestätigungssignal 82 zur Bestätigung, dass die Sensorvorrichtung 4 vollständig konfiguriert und einsatzbereit ist. Nachdem das Bestätigungssignal 82 aufgrund der blockierten zweiten Datenverbindung 14 ausbleibt, unternimmt der zweite Deserialisierer 24 weitere Versuche zur Konfiguration des ersten Serialisierers 18 durch wiederholte Übertragungen des Konfigurationsdatenstroms 23. Bis zum Abschluss der Konfigurationsphase fängt die Aufzeichnungsvorrichtung 2 alle wiederholt übertragenen Konfigurationsdatenströme 23 ab, sodass die wiederholten Konfigurationsversuche wirkungslos bleiben.

Nach Speicherung der Konfigurationsdatenstroms 23 geht die Konfigurationsvorrichtung 28 in einen Konfigurationsermittlungsmodus 86, innerhalb dessen die Konfigurationsvorrichtung 28 die vorhergehend für eine der Figuren 2, 3 oder 4 beschriebenen Arbeitsschritte zur Ermittlung einer Konfiguration bzw. Registersetzung des ersten Deserialisierers 9 durchführt. Nach Ermittlung der Konfiguration erstellt die Konfigurationsvorrichtung 28 den Deserialisierer-Konfigurationsdatenstrom 30 und übermittelt diesen zur Konfiguration des ersten Deserialisierers 9 an selbigen.

Nachdem die Konfiguration des ersten Deserialisierers 9 abgeschlossen und die Aufzeichnungsvorrichtung 2 damit vollständig konfiguriert und einsatzbereit ist, beendet die Aufzeichnungsvorrichtung 2 die Konfigurationsphase und hebt die Blockade der zweiten Datenverbindung 14 auf. Die Aufzeichnungsvorrichtung 2 geht in einen Normalbetrieb über, innerhalb dessen sie jede Kommunikation zwischen Sensorvorrichtung 4 und Empfangsvorrichtung 6 unverändert weiterleitet. Im Normalbetrieb können Sensorvorrichtung 4 und Empfangsvorrichtung 6 Daten austauschen, als wäre die Aufzeichnungsvorrichtung 2 nicht vorhanden. Der erste vom zweiten Deserialisierer 24 nach Abschluss der Konfigurationsphase übertragene Konfigurationsdatenstrom 23 erreicht ordnungsgemäß den zweiten Serialisierer 18. Nach Abschluss der Konfiguration des zweiten Serialisierers 18 bestätigt die Sensorvorrichtung 4 durch Übertragung des Bestätigungssignals 82 die Einsatzbereitschaft der Sensorvorrichtung. Nach Empfang des Bestätigungssignals 82 geht auch die Empfangsvorrichtung 6 in einen Normalbetrieb über, woraufhin der in der Abbildung der Figur 1 dargestellte Gesamtaufbau einsatzbereit ist.

## Patentansprüche

1. Aufzeichnungsvorrichtung (2) für einen Mitschnitt eines serialisierten, von einer Sensorvorrichtung (4) zu einer Empfangsvorrichtung (6) fließenden Bilddatenstroms (22), die Aufzeichnungsvorrichtung (2) umfassend:
- eine erste Datenschnittstelle (8), die für eine Einrichtung einer ersten Datenverbindung (12) zwischen der ersten Datenschnittstelle (8) und der Sensorvorrichtung (4) zur Übertragung des Bilddatenstroms (22) an die erste Datenschnittstelle (8) ausgestaltet ist;
- einen ersten Deserialisierer (9), eingerichtet zur Deserialisierung des an der ersten Datenschnittstelle (8) aufgenommenen Bilddatenstroms (22); und
- eine Speichervorrichtung (5), die eingerichtet ist, den vom ersten Deserialisierer (9) deserialisierten Bilddatenstrom (22) mitzuschneiden und Bilddaten aus dem Bilddatenstrom (22) auf einem Speichermedium (7) zu speichern;
**gekennzeichnet durch** eine Konfigurationsvorrichtung (28), die eingerichtet ist, einen von der Empfangsvorrichtung (6) übertragenen Konfigurationsdatenstrom (23) zur Konfiguration eines Serialisierers (18), der zur Serialisierung eines von einem Sensor (20) ausgegebenen Bilddatenstroms (22) und zur Einspeisung des serialisierten Bilddatenstroms (22) auf die erste Datenverbindung (12) in der Sensorvorrichtung (4) angeordnet ist, mitzuschneiden;
den Mitschnitt der Konfigurationsdaten zu analysieren und anhand der Analyse eine Aufbereitung des serialisierten Bilddatenstroms (22) durch den in der Sensorvorrichtung (4) angeordneten Serialisierer (18) zu ermitteln;
mittels der als Ergebnis der Analyse gewonnenen Informationen eine Konfiguration (52) des ersten Deserialisierers (9) zu ermitteln, die den ersten Deserialisierer (9) einrichtet, den von dem Sensor (20) ausgegebenen Bilddatenstrom (22) zu rekonstruieren; und
den ersten Deserialisierer (9) gemäß der ermittelten Konfiguration (52) des ersten Deserialisierers (9) zu konfigurieren.

2. Aufzeichnungsvorrichtung (2) gemäß Anspruch 1, umfassend:
- eine zweite Datenschnittstelle (10), die für eine Einrichtung einer zweiten Datenverbindung (14) zwischen der zweiten Datenschnittstelle (10) und der Empfangsvorrichtung (6) zur Übertragung des Bilddatenstroms (22) an die Empfangsvorrichtung (6) ausgestaltet ist; und
- einen ersten Serialisierer (11), der eingerichtet ist, den Bilddatenstrom (22) nach dessen Mitschnitt durch die Speichervorrichtung (5) wieder zu serialisieren und den wieder serialisierten Bilddatenstrom (22) durch die zweite Datenschnittstelle (10) auszugeben, und der eine Vielzahl von Eingangspins (PS1, ..., PS10) zur Aufnahme von Bilddaten umfasst;
**dadurch gekennzeichnet, dass** die Konfigurationsvorrichtung (28) eingerichtet ist, einen von der Empfangsvorrichtung (6) über die zweite Datenverbindung (14) an die zweite Datenschnittstelle (10) übertragenen Konfigurationsdatenstrom (23) zur Konfiguration eines zweiten Serialisierers (18), der zur Serialisierung des über die erste Datenverbindung (12) übertragenen Bilddatenstroms (22) in der Sensorvorrichtung (4) angeordnet ist, mitzuschneiden;
den Mitschnitt der Konfigurationsdaten zu analysieren und anhand der Analyse zu ermitteln, wie der Bilddatenstrom (22) für den ersten Serialisierer (11) aufzubereiten und auf die Eingangspins (PS1, ..., PS10) des ersten Serialisierers (11) zu verteilen ist; und
die Konfiguration (52) des ersten Deserialisierers (9) derart auszugestalten, dass die Konfiguration (52) des ersten Deserialisierers (9) den ersten Deserialisierer (9) einrichtet, den Bilddatenstrom (22) wie in der Analyse ermittelt aufzubereiten und auf die Eingangspins (PS1, ..., PS10) des ersten Serialisierers (11) zu verteilen.

3. Aufzeichnungsvorrichtung (2) gemäß Anspruch 2, wobei der erste Serialisierer (11) und der zweite Serialisierer (18) derselben Baureihe angehören und die Aufzeichnungsvorrichtung (2) eingerichtet ist, mittels des Konfigurationsdatenstroms (23) den ersten Serialisierer (11) zu konfigurieren; oder
der erste Serialisierer (11) und der zweite Serialisierer (18) unterschiedlichen Baureihen angehören und die Konfigurationsvorrichtung (2) eingerichtet ist, die durch den Konfigurationsdatenstrom (23) vorgegebene Konfiguration des zweiten Serialisierers (18) in eine technisch gleichwirkende Konfiguration (40) des ersten Serialisierers (11) zu überführen und den ersten Serialisierer (11) gemäß der technisch gleichwirkenden Konfiguration zu konfigurieren.

4. Aufzeichnungsvorrichtung (2) gemäß Anspruch 3, die eingerichtet ist, den Konfigurationsdatenstrom (23) derart abzufangen, dass die Empfangsvorrichtung (6) statt des zweiten Serialisierers (18) mittels des Konfigurationsdatenstroms (23) den ersten Serialisierer (11) konfiguriert.

5. Aufzeichnungsvorrichtung (2) gemäß Anspruch 4, die eingerichtet ist, bis zum Abschluss der Konfiguration des ersten Deserialisierers (9) von der Empfangsvorrichtung (6) wiederholt übertragene Konfigurationsdatenströme (23), insbesondere alle übertragenen Konfigurationsdatenströme (23), abzufangen.

6. Aufzeichnungsvorrichtung (2) gemäß Anspruch 5, die eingerichtet ist, nach Abschluss der Konfiguration des ersten Deserialisierers (9) wiederholt übertragene Konfigurationsdatenströme (23) an die Sensorvorrichtung (4) weiterzuleiten, um den zweiten Serialisierer (18) zu konfigurieren.

7. Aufzeichnungsvorrichtung (2) gemäß Anspruch 6, die eingerichtet ist, ein von der Sensorvorrichtung (4) nach Abschluss der Konfiguration des zweiten Serialisierers (18) übertragenes Bestätigungssignal (82) zur Bestätigung einer Einsatzbereitschaft der Sensorvorrichtung (4) an die Empfangsvorrichtung (6) weiterzuleiten.

8. Aufzeichnungsvorrichtung (2) gemäß einem der vorhergehenden Ansprüche, deren Konfigurationsvorrichtung (28) eingerichtet ist, für die Analyse eine bestehende Konfiguration eines zweiten Deserialisierers (24), der zur Deserialisierung des über die zweite Datenverbindung (14) übertragenen Bilddatenstroms (22) in der Empfangsvorrichtung (6) verbaut ist, auszulesen und bei der Ermittlung der Konfiguration (52) des ersten Deserialisierers (9) zu berücksichtigen.

9. Aufzeichnungsvorrichtung (2) gemäß einem der Ansprüche 2 bis 8, deren Konfigurationsvorrichtung (28) eingerichtet ist, bei der Ermittlung der Konfiguration (52) des ersten Deserialisierers (9) eine Netzliste (54) zu berücksichtigen, die Datenverbindungen von Eingangspins (PS1, ..., PS10) des ersten Serialisierers (11) mit einer Anzahl interner Datenleitungen (L1, ..., L10) der Aufzeichnungsvorrichtung (2) zur Übertragung von Bilddaten in die Eingangspins (PS1, ..., PS10) beschreibt.

10. Aufzeichnungsvorrichtung (2) gemäß Anspruch 1, deren Konfigurationsvorrichtung (2) eingerichtet ist, zur Ermittlung der Konfiguration (52) des ersten Deserialisierers (9)
- eine erste Abstrahierungsabbildung (42) zu konsultieren, die möglichen Konfigurationen (40) des Serialisierers (11), insbesondere allen möglichen Konfigurationen (40) des Serialisierers (11), jeweils eine technische Funktionalität (44) des Serialisierers (11) zuordnet;
- durch Anwendung der ersten Abstrahierungsabbildung (42) auf die Konfiguration (40) des Serialisierers (11) eine Funktionalität (44) des Serialisierers (11) zu ermitteln;
- zumindest eine Kompatibilitätsabbildung (46, 56) zu konsultieren, die möglichen Funktionalitäten (44) des Serialisierers (11), insbesondere allen möglichen Funktionalitäten (44) des Serialisierers (11), jeweils eine Funktionalität (48) des ersten Deserialisierers (9) zuordnet,;
- mittels Anwendung der Kompatibilitätsabbildung (46, 56) auf die ermittelte Funktionalität (44) des Serialisierers (11) eine Funktionalität (48) des ersten Deserialisierers (9) zu ermitteln;
- eine erste Konkretisierungsabbildung (50) zu konsultieren, die Funktionalitäten (48) des ersten Deserialisierers (9), insbesondere allen Funktionalitäten (48) des ersten Deserialisierers (9), jeweils eine Konfiguration (52) des ersten Deserialisierers (9) zuordnet; und
- durch Anwendung der ersten Konkretisierungsabbildung (50) auf die ermittelte Funktionalität (48) des ersten Deserialisierers (9) die Konfiguration (52) des ersten Deserialisierers (9) zu ermitteln.

11. Aufzeichnungsvorrichtung (2) gemäß Anspruch 10, wobei eine Kompatibilitätsabbildung als Funktionalitätsabbildung (46) ausgestaltet ist, die möglichen Funktionalitäten (44), insbesondere allen möglichen Funktionalitäten (44), des ersten Serialisierers (11) unmittelbar jeweils eine Funktionalität (48) des ersten Deserialisierers (9) zuordnet.

12. Aufzeichnungsvorrichtung (2) gemäß Anspruch 10, wobei eine Kompatibilitätsabbildung
- eine zweite Abstrahierungsabbildung (58) umfasst, die möglichen Funktionalitäten (44) des Serialisierers (11), insbesondere allen möglichen Funktionalitäten (44) des Serialisierers (1)), jeweils eine Spezifikation (60) des Bilddatenstroms (22) zuordnet, und
- eine zweite Konkretisierungsabbildung (62) umfasst, die möglichen Spezifikationen (60) des Bilddatenstroms (22), insbesondere allen möglichen Spezifikationen (60) des Bilddatenstroms (22), jeweils eine Funktionalität (48) des ersten Deserialisierers (9) zuordnet;

13. Aufzeichnungsvorrichtung (2) gemäß Anspruch 10, deren Konfigurationsvorrichtung (28) eingerichtet ist, zur Ermittlung der Funktionalität (48) des ersten Deserialisierers (9)
eine gemäß Anspruch 11 ausgestaltete erste Kompatibilitätsabbildung (46) zu konsultieren und auf die ermittelte Funktionalität (44) des ersten Serialisierers (11) anzuwenden und
eine gemäß Anspruch 12 ausgestaltete zweite Kompatibilitätsabbildung (56) zu konsultieren und auf die ermittelte Funktionalität (44) des ersten Serialisierers (11) anzuwenden.

14. Computerimplementiertes Verfahren zur Einrichtung eines ersten Deserialisierers (9) einer Aufzeichnungsvorrichtung (2), die zur Anfertigung eines Mitschnitts eines serialisierten, von einer Sensorvorrichtung (4) zu einer Empfangsvorrichtung (6) fließenden Bilddatenstroms (22) ausgestaltet ist und die folgenden Komponenten umfasst:
- eine erste Datenschnittstelle (8), die für eine Einrichtung einer ersten Datenverbindung (12) zwischen der ersten Datenschnittstelle (8) und der Sensorvorrichtung (4) zur Übertragung des Bilddatenstroms (22) ausgestaltet ist;
- einen ersten Deserialisierer (9), eingerichtet zur Deserialisierung des an der ersten Datenschnittstelle (8) aufgenommenen Bilddatenstroms (22); und
- eine Speichervorrichtung (5), die eingerichtet ist, den vom ersten Deserialisierer (9) deserialisierten Bilddatenstrom (22) mitzuschneiden und Bilddaten aus dem Bilddatenstrom (22) auf einem Speichermedium (7) zu speichern;
das Verfahren umfassend: eine Einrichtung der ersten Datenverbindung (12);
**gekennzeichnet durch** einen Mitschnitt eines von der Empfangsvorrichtung (6) über die zweite Datenverbindung (14) übertragenen Konfigurationsdatenstroms (23), der für eine Einrichtung eines Serialisierers (18), der zur Serialisierung eines von einem Sensor (2) ausgegebenen Bilddatenstroms (22) und zur Einspeisung des serialisierten Bilddatenstrom (22) auf die erste Datenverbindung (12) in der Sensorvorrichtung (14) angeordnet ist, vorgesehen ist;
eine Analyse des Mitschnitts der Konfigurationsdaten und eine Ermittlung, anhand der Analyse, einer Aufbereitung des serialisierten Bilddatenstroms (22) durch den in der Sensorvorrichtung (4) angeordneten Serialisierers (18);
eine Ermittlung, aus den durch die Analyse gewonnenen Informationen, einer Konfiguration (52) des ersten Deserialisierers (9), die den ersten Deserialisierer (9) einrichtet, den von dem Sensor (20) ausgegebenen Bilddatenstrom zu rekonstruieren; und
eine Konfiguration des ersten Deserialisierers (11) gemäß der ermittelten Konfiguration (52).
